# EUROPÄISCHE PATENTSCHRIFT

(11) **EP 2 550 234 B1**
(45) Veröffentlichungstag und Bekanntmachung des Hinweises auf die Patenterteilung: **11.12.2019**
(21) Anmeldenummer: 11713722.4
(22) Anmeldetag: 21.03.2011
(51) Int. Cl.: B81C 1/00, G01L 9/00

(54) **VERFAHREN ZUR HERSTELLUNG EINER MIKROELEKTROMECHANISCHEN VORRICHTUNG UND MIKROELEKTROMECHANISCHE VORRICHTUNG**
METHOD FOR PRODUCING A MICROELECTROMECHANICAL DEVICE AND MICROELECTROMECHANICAL DEVICE
PROCÉDÉ DE FABRICATION D'UN DISPOSITIF MICROÉLECTROMÉCANIQUE ET DISPOSITIF MICROÉLECTROMÉCANIQUE

(30) Priorität: 22.03.2010 EP 10157193
(43) Veröffentlichungstag der Anmeldung: 30.01.2013
(73) Patentinhaber: Elmos Semiconductor Aktiengesellschaft, 44227 Dortmund (DE)
(72) Erfinder: TEN-HAVE, Arnd, 44227 Dortmund (DE)
(74) Vertreter: dompatent von Kreisler Selting Werner - Partnerschaft von Patent- und Rechtsanwälten mbB
(86) Internationale Anmeldenummer: PCT/EP2011/054220
(87) Internationale Veröffentlichungsnummer: WO 2011/117181

(56) Entgegenhaltungen:
- DE-B3-102008 035 055
- US-A1- 2005 287 760

## Beschreibung

Die Erfindung betrifft eine mikroelektromechanische Vorrichtung sowie ein Verfahren zur Herstellung einer mikroelektromechanischen Vorrichtung.

Die Erfindung betrifft ganz allgemein eine zu herkömmlichen Halbleiterprozessen kompatible mikroelektromechanische Vorrichtung mit bezüglich in diese monolithisch integrierten mikroelektronischen Komponenten hochgenau justierten mikromechanischen Komponenten. Eine spezielle beispielhafte Ausprägung einer derartigen mikroelektromechanischen Vorrichtung ist ein mikromechanischer CMOS-Drucksensor mit niedriger Fertigungsstreuung.

Bei mikroelektromechanischen Vorrichtungen ist die exakte relative Positionierung von in einem Halbleitersubstrat integrierten elektronischen Bauelementen, insbesondere piezo-resistiven Widerständen oder Transistoren, zu ebenfalls in dem Halbleitersubstrat integrierten mikromechanischen Strukturen für die ordnungsgemäße Funktion der Vorrichtung von großer Bedeutung. Derartige mikroelektromechanische Vorrichtungen weisen mikromechanische Bauelemente auf, deren Funktion beispielsweise durch mechanische Materialspannungen einerseits beabsichtigt, also konstruktiv bedingt, andererseits aber auch parasitär beeinflusst ist. Typischerweise werden die elektronischen sowie mikromechanischen Bauelemente in der Mikroelektromechanik planar durch Photolithographie hergestellt. Die mikromechanischen Bauelemente können beispielsweise allseitig eingespannte aber auch nicht allseitig eingespannte Platten, Membranen und Balken sowie auch komplexere Formen aufweisen. Als Beispiele für derartige mikromechanische Bauelemente können hier einseitig eingespannte Balken (Beams, Cantilever) für schwingende Systeme, Druckmembranen für Druck-Sensoren, oder zentral gelagerte Kreisscheiben für Oszillatoren genannt werden.

Die mikromechanische Fertigung dieser mikromechanischen Bauelemente bzw. Strukturen ist bezogen auf die absoluten Dimensionen der mikromechanischen Bauelemente, die typischerweise im µm- oder maximal mm-Bereich liegen, mit wesentlich höheren relativen Fertigungstoleranzen behaftet als dies bei konventioneller Nicht-Mikromechanik der Fall ist. Dabei ist bei der Gestaltung der Herstellungsprozesse besonders darauf Wert zu legen, dass die Auslegung und Fertigungsmethodik so gewählt wird, dass die sich ergebende Prozesskonstruktion hinsichtlich des Prozessresultats (nämlich der mikroelektromechanischen Vorrichtung) robust auf die besagten unvermeidbaren Parameterschwankungen reagiert. Hierbei steht die Konstruktion der herzustellenden Vorrichtung Hand in Hand mit der Prozesskonstruktion; beide sind nicht vollständig trennbar.

Insbesondere für solche mikromechanischen Bauelemente, bei denen die Größen mechanischer Materialspannungen messtechnisch erfasst werden, der hierfür vorgesehene örtliche Bereich auftretender maximaler mechanischer Spannung jedoch nicht homogenisiert werden kann, gleichzeitig aber dennoch funktional oder parasitär von Bedeutung ist, ist die Lage der für mechanische Materialspannungen empfindlichen mikroelektronischen Bauteile gegenüber der Lage der den Materialspannungen ausgesetzten mikromechanischen Bauelemente so zu kontrollieren, dass keine relevanten Fertigungsschwankungen auftreten und somit auch keine relevanten Auswirkungen einer Fehljustage zwischen den mikroelektronischen und den mikromechanischen Bauelementen auftreten.

Aus US-A-2005/287760 ist ein Verfahren zur Herstellung einer mikroelektromechanischen Vorrichtung (MEMS in einem für die Herstellung integrierter elektronischer Bauteile geeigneten Materialsubstrat bekannt, bei dem ein Materialsubstrat bereitgestellt wird, in dem ein elektronisches Bauteil ausgebildet wird. Auf dem Materialsubstrat werden für die Funktion des elektronischen Bauteils erforderliche Kontakte und Leiterbahnen aus einem im Falle eines Ätzens des Materialsubstrats jeweils als Ätzstopp wirkenden ersten Ätzstopp-Material, nämlich Aluminium, selektiv ausgebildet. Aus diesem Ätzstopp-Material wird bei Ausbildung der Bauteilkomponente des elektronischen Bauteils auch auf dem Materialsubstrat längs zumindest eines Teilabschnitt eines Randes der Oberflächenstruktur ein diesen Teilabschnitt begrenzendes Begrenzungsgebiet ausgebildet, indem das Aluminium der Leiterbahnen als Ätzstopp-Maske für die Herstellung der mechanischen Strukturen der MEMS-Struktur dient. Das so ausgebildete Materialsubstrat wird zur Bildung der Oberflächenstruktur selektiv geätzt, indem ein Rand des Begrenzungsgebiets die Position der auszubildenden Oberflächenstruktur auf dem Materialsubstrat definiert.

Eine Aufgabe der Erfindung ist es, die für die Funktionsweise mikroelektromechanischer Vorrichtungen relevanten mikromechanischen Struktur- bzw. Bauelemente mit mikroelektronischen Struktur- bzw. Bauelementen durch eine Prozesskonstruktion so zu verkoppeln, dass durch Selbstjustage praktisch keine Justagefehler mehr auftreten können.

Zur Lösung dieser Aufgabe werden mit der Erfindung ein Verfahren zur Herstellung einer mikroelektromechanischen Vorrichtung in einem für die Herstellung integrierter elektronischer Bauteile geeigneten Materialsubstrat, insbesondere Halbleitersubstrat, mit den im Anspruch 1 angegebenen Merkmalen und eine mikroelektromechanische Vorrichtung gemäß Anspruch 6 vorgeschlagen. Die Unteransprüche betreffen einzelne Ausgestaltungen der Erfindung.

Nach dem erfindungsgemäßen Verfahren werden in einem Materialsubstrat sowohl mikromechanische als auch mikroelektronische Bauteile integriert. Die mikromechanischen Bauteile sind dabei im Regelfall durch eine Oberflächenstruktur, die im Laufe des Herstellungsprozesses zwischenzeitlich oder auch dauerhaft entsteht, definiert. D.h., dass die hergestellte Vorrichtung nicht notwendigerweise die Oberflächenstruktur aufweisen muss, sondern vielmehr die Struktur lediglich während der Herstellung gegeben sein muss. Die Oberflächenstruktur ist z.B. durch mindestens eine Kante definiert und kann mindestens eine Vertiefung und/oder mindestens eine Erhöhung aufweisen. Im Falle einer Vertiefung bzw. Erhöhung kann bzw. können diese allseitig oder teilweise umschlossen bzw. im einfachsten Fall als Stufe ausgebildet sein. Bei einem Drucksensor mit einer allseitig eingespannten, eine Kammer überspannenden Membran sind die mikromechanischen Bauteile als sogenannte Race-Tracks ausgebildet, bei denen es sich um in das Materialsubstrat eingebrachte Vertiefungen handelt, um die Membran in ihrem kammerwandnahen Bereich zu verdünnen und damit flexibler zu gestalten. Diese Vertiefungen erstrecken sich längs des an die Kammerwand angrenzenden Bereichs der Membran, wobei zwischen mindestens zwei benachbarten Vertiefungen ein oder mehrere elektronische Bauteile zum Sensieren mechanischer Spannungen in der Membran angeordnet sind, welche wiederum bei einer Verformung der Membran infolge einer Druck- bzw. Kraftausübung auf die Membran entstehen. Die Erfindung ist aber auf den Anwendungsfall eines Drucksensors nicht beschränkt.

Erfindungsgemäß wird für die Herstellung einer mikroelektromechanischen Vorrichtung ein Planar-Halbleiterprozess mit Photolithographie eingesetzt. Derartige Prozesse umfassen Prozessschritte, bei denen auf dem (zumeist Halbleiter-)Substrat entweder Material abgeschieden wird, das anschließend strukturiert wird, oder aber Material direkt strukturiert abgeschieden wird. Die relative Lage (in x- und y-Richtung) der einzelnen "Materialinseln" einer derartigen strukturierten Materialschicht ist prozessbedingt hochgenau. Erfindungsgemäß wird nun exakt diese Eigenschaft ausgenutzt, um die relative Lage der mikromechanischen (Oberflächen-)Strukturen zu den mikroelektronischen Bauteilen selbstjustierend zu gestalten.

Dies gelingt dadurch, dass ein erstes (Ätzstopp-)Material, das die Lage eines elektronischen Bauteils (innerhalb eines im Materialsubstrat ausgebildeten Aktivgebiets) definiert und/oder für die Funktion des elektronischen Bauteils erforderlich ist, aber auch zur Begrenzung bzw. Lagedefinition der mikromechanischen (Oberflächen-)Struktur verwendet wird, die in das Materialsubstrat durch Ätzen eingebracht wird, wobei dieser Prozessschritt zur Vorbehandlung des Materialsubstrats zwecks späterer Ausbildung/Vervollständigung der Oberflächenstruktur eingesetzt werden kann. Dabei muss dieses Material beim (späteren) Ätzen als Maskierung für das unterhalb des Ätzstopp-Materials befindliche Material des Substrats fungieren. Beispielsweise kann es sich bei diesem ersten Material um ein elektrisch leitendes Material handeln, das z.B. als Gate eines piezo-resistiven Transistors bzw. als Widerstandsschicht oder Field-Shield eines piezo-resistiven Widerstandes dient. Das in diesem Falle elektrisch leitende Material muss also gegenüber dem Materialsubstrat (beispielsweise Halbleitersubstrat) als Ätzstopp-Maskierung fungieren, wenn die mikromechanische (Oberflächen-)Struktur (z.B. Vertiefung oder Stufe) durch einen Ätzvorgang ausgebildet wird.

Im Falle eines auf einem Siliziumsubstrat ausgeführten CMOS-Planarprozesses kann es sich bei dem ersten (Ätzstopp-)Material um polykristallines Silizium (nachfolgend Polysilizium genannt) handeln. Im Regelfall ist die Oberseite des Halbleitersubstrats z.B. zum Schutz der integrierten Strukturen mit einer Passivierungsschicht versehen. Es können aber auch andere funktional wirkende Arten von Materialschichten aus jeweils angepasstem Material aufgebracht sein. Zur Ausbildung z.B. einer Vertiefung (als Oberflächenstruktur) durch Ätzen muss zunächst in die Passivierungsschicht eine mit der später einzubringenden Vertiefung fluchtende Öffnung ausgebildet werden. Dies erfolgt photolithographisch und durch Ätzen, wobei das Polysilizium des Begrenzungsgebiets sowie das Siliziumsubstrat selbst als Ätzstopp dienen. Durch Verwendung eines anderen Materials (gasförmig oder flüssig) wird dann anschließend die Vertiefung in das Siliziumsubstrat hinein geätzt. Hierbei müsste nun das Polysilizium des Begrenzungsgebiets als Ätzstopp-Maskierung und zum Schutze des darunterliegenden Siliziumsubstrats dienen. Derart selektiv unterschiedlich stark ätzende Materialien sind aber nur mit großem Aufwand herstellbar, so dass ein anderer Mechanismus gefunden werden muss, es sei denn, dass anstelle des Polysiliziums ein anderes Material eingesetzt wird, das sowohl als Bauteilkomponente für das mikroelektronische Bauteil und als Ätzstopp-Material für das Begrenzungsgebiet dienen kann.

Bei Verwendung von Polysilizium ist es daher zweckmäßig, wenn auf dem Materialsubstrat im Bereich der später auszubildenden Oberflächenstruktur (z.B. Vertiefung) ein einen Ätzprozess zumindest verzögerndes zweites Ätzstopp-Material aufgebracht wird. Dieses zweite Ätzstopp-Material kann beispielsweise Siliziumoxid sein, das thermisch oder durch Abscheidung ausgebildet wird, wie dies bei Silizium-Halbleiterbauelementherstellungsprozessen bekannt ist. Befindet sich nun dieses zweite Ätzstopp-Material unter dem Begrenzungsgebiet aus dem ersten Ätzstopp-Material, so wird beim Ätzen der Öffnung in der Passivierungsschicht nicht nur diese bis zum ersten Ätzstopp-Material durchgeätzt, sondern auch das zweite Ätzstopp-Material bis zum Silizium-Halbleitermaterial. Damit ist die Struktur des Begrenzungsgebiets auf das Silizium-Halbleitersubstrat übertragen worden. Wird dann anschließend zur Herstellung der Oberflächenstruktur in und/oder auf dem Silizium-Halbleitersubstrat dieses geätzt, so wirkt das zweite Ätzstopp-Material als Maske für die Formung der Oberflächenstruktur.

Das zuvor als zweites "Ätzstopp-Material" bezeichnete Material braucht nicht notwendigerweise vollständig resistent gegenüber demjenigen Ätz-Verfahren bzw. Ätzmittel zu sein, mit dessen Hilfe die Vertiefung in das Materialsubstrat hinein geätzt wird. Es reicht aus, wenn dieses zweite Ätzstopp-Material weniger empfindlich gegenüber dem für die Ätzung der Vertiefung verwendeten Ätz-Verfahren bzw. Ätzmittel als das Materialsubstrat ist. Durch entsprechende Wahl der Dicke dieses zweiten Ätzstopp-Materials in Relation zur Tiefe der in das Materialsubstrat zu ätzenden Vertiefung und der Relation der Ätzraten des ersten und des zweiten Ätzstopp-Materials kann damit erreicht werden, dass das zweite Ätzstopp-Material bis zu dem Zeitpunkt, an dem z.B. eine Vertiefung in der gewünschten Eindringtiefe in das Materialsubstrat hinein geätzt worden ist, noch nicht vollständig "durchgeätzt" ist.

In vorteilhafter Weiterbildung der Erfindung kann also, wie bereits zuvor erwähnt, auf dem Materialsubstrat eine (z.B. Passivierungs-)Schicht aufgebracht werden, in die in Vorbereitung der Ausbildung der Oberflächenstruktur eine mit der in dem Materialsubstrat auszubildenden Oberflächenstruktur (z.B. Vertiefung) fluchtende Öffnung insbesondere durch Ätzen eingebracht wird, und dass durch die Öffnung der (Passivierungs-)Schicht hindurch in dem durch das Begrenzungsgebiet begrenzten Bereich des Materialsubstrats in dieses die Oberflächenstruktur geätzt wird.

Wie ebenfalls bereits zuvor beschrieben, kann gemäß einer weiterführenden Ausgestaltung der Erfindung bei im Wesentlichen gleichen Materialien für das Materialsubstrat und das erste Ätzstopp-Material unterhalb des die Lage der Oberflächenstruktur definierenden Begrenzungsgebiets auf dem Materialsubstrat ein zweites Ätzstopp-Material ausgebildet werden, auf dem das Begrenzungsgebiet zumindest teilweise ausgebildet ist, wobei dieses zweite Ätzstopp-Material bei einem Ätzvorgang zum Ätzen der Oberflächenstruktur in das Materialsubstrat oder zum Vorbehandeln des Materialsubstrats für die (anschließende) Ausbildung der Oberflächenstruktur mit einer kleineren Rate als der des Materialsubstrats weggeätzt wird.

In weiterer Ausgestaltung der Erfindung kann als Oberflächenstruktur mindestens eine Vertiefung in der Oberseite des Materialsubstrats ausgebildet werden, wobei in der Unterseite des Materialsubstrats insbesondere durch Ätzen eine Kammer ausgebildet wird, so dass insgesamt ein Materialsubstrat mit einer überdeckten Kammer entsteht, wobei die Vertiefung innerhalb des die Kammer überspannenden Bereichs des Materialsubstrats angeordnet wird. Auf diese Weise kann ein Absolut- oder Relativdrucksensor gebildet werden. Die Kammer kann einseitig offen oder aber als sogenannte "Buried Cavity" ausgebildet sein.

Gemäß einer Ausgestaltung der Erfindung ist das elektronische Bauteil ein Transistor mit einem Gate und die Bauteilkomponente das Gate des Transistors oder das elektronische Bauteil ein Widerstand und die Bauteilkomponente eine beispielsweise Polysilizium-Widerstandsschicht oder ein Field-Shield des Widerstandes.

Gemäß einer weiteren Ausgestaltung der Erfindung ist das erste (Ätzstopp-) Material beispielsweise elektrisch leitend und weist insbesondere polykristallines Silizium auf. Längs eines Begrenzungsrandes bzw. Begrenzungsrandabschnitts der Oberflächenstruktur in dem Substrat erstreckt sich ein weiteres Gebiet aus einem zweiten Material, das elektrisch isolierend ist und insbesondere Siliziumoxid aufweist und auf dem das erste Material angeordnet ist. Alternativ kann man als erstes (Ätzstopp-)Maskierungsmaterial auch Metall verwenden (z.B. AI). Dann bedarf es des zweiten Ätzstopp-Materials nicht. Das Metall kann z.B. als Gate eines Transistors verwendet werden und gleichzeitig (im gleichen Prozessschritt) als Material für das die Ätzung lateral begrenzende Begrenzungsgebiet aufgebracht bzw. gebildet werden.

Ferner ist gemäß einer vorteilhaften Ausgestaltung der Erfindung an der Unterseite des Substrats eine Kammer ausgebildet, wobei die Oberflächenstruktur mindestens eine Vertiefung innerhalb eines die Kammer überspannenden Bereichs des Substrats aufweist.

Die Erfindung wird nachfolgend anhand zweier Ausführungsbeispiele, bei denen die mikromechanischen Oberflächenstrukturen jeweils mehrere Vertiefungen aufweisen, und unter Bezugnahme auf die Zeichnung näher erläutert. Im Einzelnen zeigen dabei:
- Fig. 1: eine perspektivische Schnittdarstellung eines mikroelektromechanischen Drucksensors als Beispiel für eine mikroelektromechanische Vorrichtung und
- Fign. 2 bis 4: Schnittdarstellungen durch das Halbleitersubstrat des mikroelektromechanischen Drucksensors gemäß Fig. 1 in verschiedenen Prozessstadien gemäß einem ersten Ausführungsbeispiel eines Herstellungsprozesses.

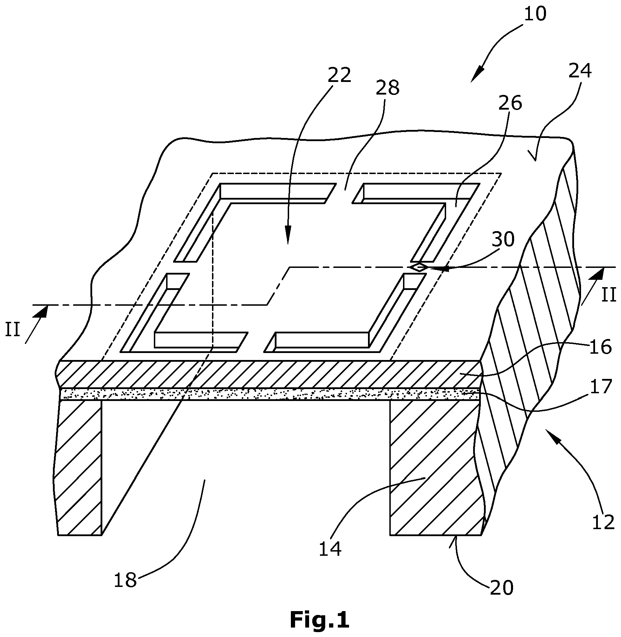

In Fig. 1 ist schematisch die Konstruktion eines mikroelektromechanischen Drucksensors 10, der in einem SOI-Halbleitersubstrat 12 ausgebildet ist. Das SOI-Halbleitersubstrat 12 ist unterteilt in einen sogenannten Handle-Wafer 14 aus Silizium, einem Top-Wafer 16 aus Silizium (mitunter auch als Device-Wafer bezeichnet) und eine zwischen beiden Wafern angeordneten SiO₂-Schicht 17. Die beiden Wafer 14,16 sind über die SiO₂-Schicht 17 miteinander verbündet. In dem Handle-Wafer 14 ist eine in diesem Ausführungsbeispiel einseitig offene Kammer 18 ausgebildet. Diese Kammer 18 könnte aber auch an der Unterseite 20 des Handle-Wafer 14 verschlossen sein.

Der Top-Wafer 16 überspannt die Kammer 18 im Handle-Wafer 14 und ist in diesem Bereich als druck- bzw. kraftempfindliche verformbare Membran 22 ausgebildet. Zu diesem Zweck sind von der Oberseite 24 des Top-Wafer 16 aus Gräben oder allgemein Vertiefungen 26 in das SOI-Substrat 12 eingebracht, die auch als "Race Tracks" bezeichnet werden. Durch diese Vertiefungen 26 wird die Dicke der Membran 22 in dessen Randbereich verringert, wobei zwischen benachbarten Gräben bzw. Vertiefungen 26 Materialstege 28 verbleiben. Im Bereich zumindest eines dieser Materialstege 28 ist ein in diesem Ausführungsbeispiel piezo-resistives mikroelektronisches Bauteil 30 integriert, das in diesem Ausführungsbeispiel als Transistor ausgebildet ist.

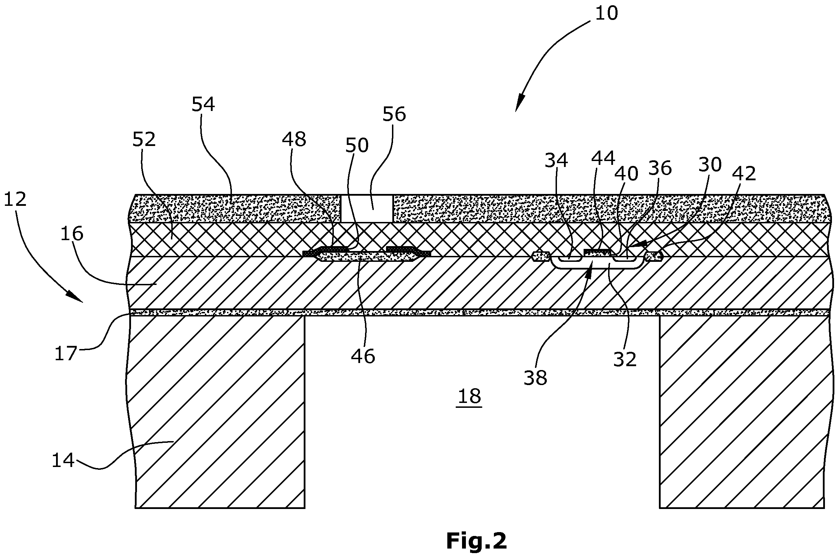

Anhand verschiedener Querschnittsansichten gemäß den Fign. 2 bis 4 soll nachfolgend auf einen möglichen Herstellungsprozess des Drucksensors 10 gemäß Fig. 1 eingegangen werden. Dabei verläuft die Linie, entlang derer gemäß den Fign. 2 bis 4 durch den Drucksensor geschnitten worden ist, so, wie in Fig. 1 bei II-II angegeben.

In einem innerhalb des Bereichs des Steges 28 ausgebildeten Aktivgebiet 32 (beispielsweise eine n-dotierte Wanne) ist der Transistor 30 ausgebildet. Der Transistor 30 weist Drain- und Source-Anschlussgebiete 34,36 sowie ein Gate-Gebiet 38 auf, über dem sich ein Gate-Oxid 40 befindet. Das Aktivgebiet 32 ist von Feldoxid 42 umgeben und damit lateral begrenzt, wie dies beispielsweise im CMOS-Prozess hergestellten Transistoren aus dem Stand der Technik bekannt ist. Auf dem Gate-Oxid 40 befindet sich eine Gate-Elektrode 44 aus beispielsweise Polysilizium, die die Lage des Transistors 30 innerhalb des Aktivgebietes 32 definiert.

Erfindungsgemäß wird nun vor dem Abscheiden des Polysiliziums für die Gate-Elektrode 44 des Transistors 30 (sowie für andere mikroelektronische Strukturen des Drucksensors 10) in einem selbstjustierenden CMOS-Prozess an denjenigen Stellen auf dem Top-Wafer 16, an denen eine Vertiefung 26 von oben hineingeätzt werden soll, ein nachfolgend mit Hard-Maske 46 bezeichnetes Material abgeschieden und anschließend strukturiert bzw. strukturiert abgeschieden. Bei diesem Material handelt es sich im vorliegenden Fall um ein thermisches Oxid oder ein CVD-Oxid, wie es auch für das Feldoxid 42 des Transistors 30 verwendet wird. Wird dann in einem späteren Prozessschritt des CMOS-Prozesses Polysilizium und insbesondere das für das Polysilizium-Gate 44 des Transistors 30 bestimmte Polysilizium abgeschieden, so wird dieses Polysilizium auch auf der Hard-Maske 46 abgeschieden, wie es in Fig. 2 gezeigt ist. Dabei begrenzt das auf der Hard-Maske 46 abgeschiedene Polysilizium in Form eines Begrenzungsgebiets 48 eine Öffnung 50, die die Lage der im Rahmen späterer Prozessschritte durch Ätzen auszubildenden Vertiefungen 26 definiert. Die Oberseite des SOI-Halbleitersubstrats 12 wird von einer Passivierungsschicht 52 (beispielsweise aus Siliziumnitrit) überdeckt.

Zur Vorbereitung der Ausbildung der Vertiefungen 26 mittels Ätzens wird nun auf der Passivierungsschicht 52 eine Lackmaske 54 aufgebracht und photolithographisch strukturiert, so dass die Lackmaske 54 an den mit den später zu ätzenden Vertiefungen 26 fluchtenden Stellen Öffnungen 56 aufweist. Fig. 2 zeigt schematisch den beispielhaft beschriebenen (Differenz-)Drucksensor 10 auf Siliziumbasis in diesem Prozessstadium.

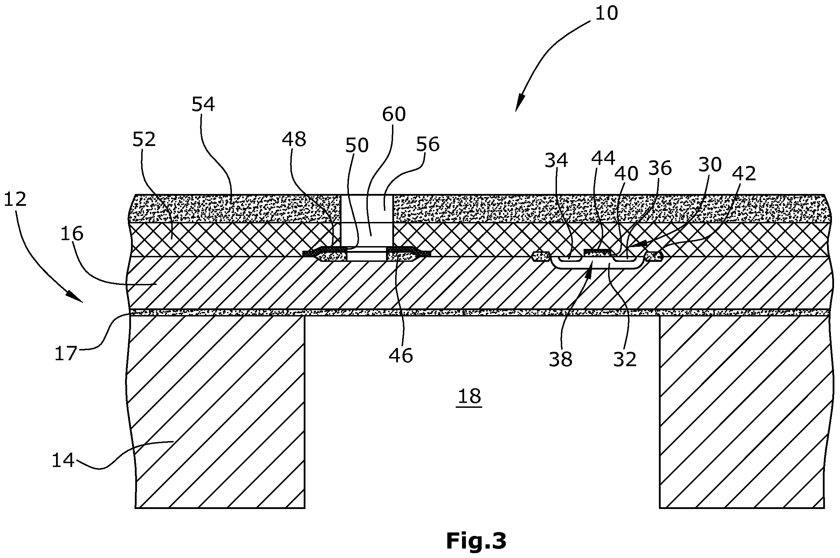

Um nun in den Top-Wafer 12 die Vertiefungen 26 ätzen zu können, muss zunächst durch die Öffnungen 56 der Lackmaske 54, durch die Passivierungsschicht 52 und die Hard-Maske 46 bis zum Silizium des Top-Wafer 16 geätzt werden. Hierbei dient das Polysilizium des Begrenzungsgebiets 48 sowie das Silizium des Top-Wafer 16 sozusagen als Ätzstopp, wobei als Ergebnis davon die von dem Begrenzungsgebiet 48 aus Polysilizium definierte Öffnung auf die Oberseite des Siliziums des Top-Wafer 16 übertragen wird. Mit anderen Worten maskiert also das Polysilizium des Begrenzungsgebiets 48 die Ätzung, so dass nur an denjenigen Stellen, an denen die Lackmaske 54 geöffnet ist (Öffnungen 56) und auf der darunter liegenden Hard-Maske 46 kein Polysilizium vorhanden ist (also im Bereich der Öffnungen 50 des Begrenzungsgebiets 48), durch die Hard-Maske 46 hindurch geätzt wird in der somit die Öffnung 50 entsteht. Somit werden also die Strukturen der Hard-Maske 46 in Lage und Dimension mit der Lage und der Dimension der Öffnung 50 im Begrenzungsgebiet 48 korreliert und automatisch justiert. Da die Lage des Begrenzungsgebiets 48 und damit dessen Öffnung 50 wiederum mit der Lage des Gates 44 des Transistors 30 korreliert und automatisch justiert ist, ist damit eine hochgenaue und reproduzierbare Relativlage von Öffnung 50 und Transistor-Gate 44 gegeben. Den Zustand nach dem zuvor beschriebenen Prozessschritt, also nach dem Vorgang des Ätzens bis zum Silizium (Polysilizium des Begrenzungsgebiets 48 bzw. Silizium des Top-Wafer 16) zeigt Fig. 3.

Ausgehend von diesem Zustand erfolgt nun die Ausbildung der Vertiefungen 26 in dem Silizium des Top-Wafer 16. Hierbei besteht eine gewisse Problematik darin, dass das nun verwendete Ätzmittel (als Gas- oder Flüssigphase) neben der gewollten Ätzung im Silizium des Top-Wafer 16 auch unbeabsichtigterweise das Polysilizium des Begrenzungsgebiets 48 angreift. Dieses Polysilizium ragt, wie anhand von Fig. 3 zu erkennen ist, in das gemäß Fig. 3 geätzte Fenster 60 der Passivierungsschicht 52 hinein. Damit verbreitert sich die Öffnung 50 des Begrenzungsgebietes 48 aus Polysilizium, was an sich nicht gewollt ist. Die ebenfalls ungewollte Übertragung dieser verbreiterten Öffnung bis zum Silizium des Top-Wafer 16 durch die Hard-Maske 46 hindurch bzw. durch Erweiterung von deren Öffnung 58 kann aber dadurch verhindert werden, dass man sich die unterschiedlichen Ätzraten, mit denen Silizium gegenüber dem Material der Hard-Maske 46 geätzt wird, zu Nutze macht. Man sollte also ein Ätzmittel oder Ätz-Verfahren verwenden, gegenüber dem bzw. bei dem das Material der Hard-Maske 46 entweder resistent ist oder aber (deutlich) weniger empfindlich ist als Silizium. Derartige Ätzmittel sind im Stand der Technik bekannt.

In der Regel liegen die Tiefen der zu ätzenden Vertiefungen 26 in der Größenordnung von einigen µm. Bei der Auslegung der Dicke der Hard-Maske 46 sollte daher darauf geachtet werden, dass die Hard-Maske 46 unter Berücksichtigung der Selektivität der Ätzung von Polysilizium und Silizium einerseits gegenüber der Ätzung von SiO₂ andererseits eine ausreichende Dicke aufweist und nicht durchgeätzt wird. Die Öffnungen 56 in der Lackmaske 54 sollten daher vorteilhafterweise größer als das Maß der zu ätzenden Vertiefungen 26 gewählt werden, da dann Justierfehler der Lackmaske 54 relativ zu dem Begrenzungsgebiet 48 keinen Einfluss mehr auf die spätere Lage der Vertiefungen 26 haben. Dies bedeutet, dass die Polysilizium-Begrenzungsgebiete 48 breiter sind als die Schwankungsbreite der Justierfehler der Lackmaske 54 gegenüber den Polysilizium-Strukturen.

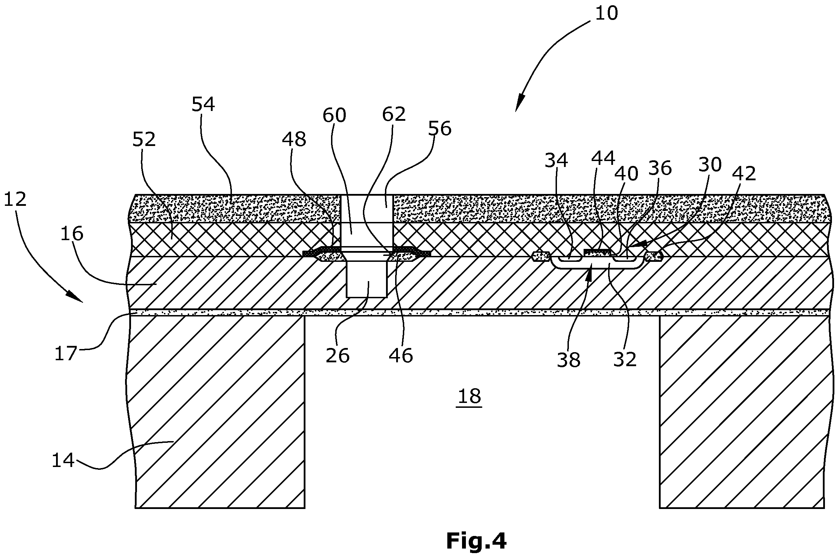

Durch die oben angegebenen allgemeinen Randbedingungen zur Wahl der Dicke der Hard-Maske 46 (unter weiterer Berücksichtigung der Größe des Unterschiedes der Ätzraten im Material der Hard-Maske 46 und im Silizium) kann also die Dicke der Hard-Maske 46 so gewählt werden, dass die Hard-Maske 46 noch nicht vollständig "durchgeätzt" ist, wenn die gewünschte Tiefe der Vertiefungen 26 erreicht ist. Damit verbleibt nach dem Ätzen auf dem Silizium des Top-Wafer 16 längs des Randes der Vertiefung 26 immer noch restliches Material der Hard-Maske 46, was dazu führt, dass die Lageposition der Vertiefung 26 wie gewünscht so ist, wie es vor dem Ätzen der Vertiefung 26 beabsichtigt war. Konstruktiv äußert sich dies in einer Schrägfläche oder in einer eine (oder mehrere) Stufe(n) aufweisenden Fläche 62 längs des oberen Begrenzungsrandes der Vertiefung 26. Diese Fläche 62 befindet sich längs des Randes der Öffnung 58 innerhalb der Hard-Maske 46. Diese Situation ist in Fig. 4 gezeigt.

## Patentansprüche

1. Verfahren zur Herstellung einer mikroelektromechanischen Vorrichtung in einem für die Herstellung integrierter elektronischer Bauteile geeigneten Materialsubstrat, insbesondere Halbleitersubstrat, wobei bei dem Verfahren
- ein Materialsubstrat (12,14,16) bereitgestellt wird, auf dem während der Herstellung der Vorrichtung mindestens eine Oberflächenstruktur (26) auszubilden ist,
- in dem Materialsubstrat (12,14,16) unter Verwendung von Prozessschritten eines herkömmlichen Verfahrens zur Herstellung integrierter elektronischer Bauteile mindestens ein mehrere Bauteilkomponenten aufweisendes elektronisches Bauteil (30) ausgebildet wird,
- auf dem Materialsubstrat (12,14,16) selektiv eine die Position des elektronischen Bauteils (30) definierende Bauteilkomponente (44) aus einem im Falle eines Ätzens des Materialsubstrats (12,14,16) und/oder im Falle eines Ätzens einer auf dem Materialsubstrat (12,14,16) angeordneten Materialschicht (52) jeweils als Ätzstopp wirkenden ersten Ätzstopp-Material ausgebildet wird, wobei diese Bauteilkomponente (44) in einem selbstjustierenden CMOS-Prozess der Herstellung weiterer Bauteilkomponenten (34, 36) des elektronischen Bauteils (30) dient,
- aus diesem Ätzstopp-Material zusammen mit der Ausbildung der Bauteilkomponente (44) des elektronischen Bauteils (30) auf dem Materialsubstrat (12,14,16) längs zumindest eines Teilabschnitts eines Randes der Oberflächenstruktur (26) zusätzlich ein diesen Teilabschnitt aufweisendes Begrenzungsgebiet (48) ausgebildet wird, das einen in dem Herstellungsprozess des ersten Ätzstopp-Materials definierten Abstand zu der das erste Ätzstopp-Material aufweisenden Bauteilkomponente (44) des elektrischen Bauteils (30) aufweist, und
- das so ausgebildete Materialsubstrat (12,14,16) zur Bildung der Oberflächenstruktur (26) selektiv geätzt wird, indem ein Rand des Begrenzungsgebiets (48) die Position der auszubildenden Oberflächenstruktur (26) auf dem Materialsubstrat (12,14,16) definiert und damit die Oberflächenstruktur (26) und das elektrische Bauteil (30) dem Abstand zwischen der das erste Ätzstopp-Material aufweisenden Bauteilkomponente (44) und dem das erste Ätzstopp-Material aufweisenden Begrenzungsgebiet (48) entsprechend voneinander entfernt angeordnet sind.

2. Verfahren nach Anspruch 1, **dadurch gekennzeichnet, dass** auf dem Materialsubstrat (12,14,16) eine Materialschicht (52) aufgebracht wird, in die in Vorbereitung der Ausbildung der Oberflächenstruktur (26) eine mit einem Rand oder Randabschnitt der Oberflächenstruktur (26) fluchtende Öffnung (60) insbesondere durch Ätzen eingebracht wird, und dass durch die Öffnung (60) der Materialschicht (52) hindurch in dem durch das Begrenzungsgebiet (48) begrenzten Bereich des Materialsubstrats (12,14,16) auf diesem der Rand oder der Randabschnitt der Oberflächenstruktur (26) geätzt wird.

3. Verfahren nach Anspruch 1 oder 2, **dadurch gekennzeichnet, dass** bei im Wesentlichen gleichen Materialien für das Materialsubstrat (12,14,16) und das erste Ätzstopp-Material unterhalb des die Lage eines Randes oder Randabschnitts der Oberflächenstruktur (26) definierenden Begrenzungsgebiets (48) auf dem Materialsubstrat (12,14,16) ein zweites Ätzstopp-Material (46) ausgebildet wird, auf dem das Begrenzungsgebiet (48) zumindest teilweise ausgebildet ist, wobei dieses zweite Ätzstopp-Material (46) bei einem Ätzvorgang zum Ätzen des Randes oder Randabschnitts der Oberflächenstruktur (26) in das Materialsubstrat (12,14,16) weggeätzt wird, und zwar mit einer kleineren Rate als derjenigen, mit der das Materialsubstrat (12,14,16) geätzt wird.

4. Verfahren nach Anspruch 3, **dadurch gekennzeichnet, dass** das Materialsubstrat (12,14,16) ein einkristallines Silizium und das erste Ätzstopp-Material polykristallines Silizium ist und dass das zweite Ätzstopp-Material (46) Siliziumoxid ist.

5. Verfahren nach einem der Ansprüche 1 bis 4, **dadurch gekennzeichnet, dass** das Materialsubstrat (12,14,16) eine Unter- und eine Oberseite (20,24) aufweist, dass die Oberflächenstruktur (26) mindestens eine Vertiefung aufweist, die in der Oberseite (24) des Materialsubstrats (12,14,16) ausgebildet wird, und dass in die Unterseite (20) des Materialsubstrats (12,14,16) insbesondere durch Ätzen eine Kammer (18) ausgebildet wird, wobei die mindestens eine Vertiefung der Oberflächenstruktur (26) innerhalb des die Kammer (18) überspannenden Bereichs (22) des Materialsubstrats (12,14,16) angeordnet wird.

6. Mikroelektromechanische Vorrichtung mit
- einem Substrat (12,14,16) mit einer Oberseite (24) und einer Unterseite (20),
- mindestens einem in dem Substrat (12,14,16) integrierten elektronischen Bauteil (30), das eine die Position des Bauteils (30) definierende Bauteilkomponente (44) aus einem ersten Material und weitere Bauteilkomponenten (34, 36) aufweist, die durch einen selbstjustierenden CMOS-Prozess selbstjustiert zur besagten Bauteilkomponente angeordnet sind, und
- mindestens einer in und/oder auf der Oberseite (24) des Substrats (12,14,16) ausgebildeten Oberflächenstruktur (26) mit einem Begrenzungsrand oder einem Begrenzungsrandabschnitt,
- wobei auf der Oberseite (24) und/oder im oberseitennahen Bereich des Substrats (12,14,16) längs des Begrenzungsrandes oder des Begrenzungsrandabschnitts der Oberflächenstruktur (26) in dem Substrat (12,14,16) in einem durch den Prozess des Ausbildens des ersten Materials definierten Abstand zur besagten Bauteilkomponente (44) des Bauteils (30) ein den Begrenzungsrand oder Begrenzungsrandabschnitt der Oberflächenstruktur (26) lateral definierendes Begrenzungsgebiet (48) aus dem ersten Material ausgebildet ist,
- wobei die Oberflächenstruktur (26) von dem elektronischen Bauteil (30) dem Abstand zwischen der das erste Material aufweisenden Bauteilkomponente (44) und dem das erste Material aufweisenden Begrenzungsgebiet (48) entsprechend voneinander entfernt angeordnet ist.

7. Vorrichtung nach Anspruch 6, **dadurch gekennzeichnet, dass** das elektronische Bauteil (30) ein Transistor mit einem Gate und die Bauteilkomponente (44) das Gate des Transistors ist oder dass das elektronische Bauteil (30) ein Widerstand und die Bauteilkomponente eine Widerstandsschicht des Widerstandes ist.

8. Vorrichtung nach Anspruch 6 oder 7, **dadurch gekennzeichnet, dass** das erste Material elektrisch leitend ist und insbesondere polykristallines Silizium aufweist und dass sich längs des Begrenzungsrandes der Oberflächenstruktur (26) in dem Substrat (12,14,16) ein weiteres Gebiet (46) aus einem zweiten Material erstreckt, das elektrisch isolierend ist und insbesondere Siliziumoxid aufweist und auf dem das erste Material angeordnet ist.

9. Vorrichtung nach einem der Ansprüche 6 bis 8, **dadurch gekennzeichnet, dass** die Oberflächenstruktur (26) mindestens eine Vertiefung aufweist, dass an der Unterseite (20) des Substrats (12,14,16) eine Kammer (18) ausgebildet ist und dass die mindestens eine Vertiefung der Oberflächenstruktur (26) innerhalb eines die Kammer (18) überspannenden Bereichs (22) des Substrats (12,14,16) angeordnet ist.

## Claims

1. A method for manufacturing a micro-electromechanical device in a material substrate suitable for manufacturing integrated electronic components, in particular a semiconductor substrate, wherein, in the method:
- a material substrate (12, 14, 16) is provided, on which at least one surface structure (26) is formed during manufacture of the device,
- at least one electronic component (30), comprising a plurality of component elements, is formed in the material substrate (12, 14, 16) using process steps of a conventional method for manufacturing integrated electronic components,
- a component element (44), selectively defining the position of the electronic component (30) on the material substrate (12, 14, 16), is formed by a first etching stop material acting as an etching stop for etching the material substrate (12, 14, 16) or a material layer (52) disposed on the material substrate (12, 14, 16), wherein, in a self-adjusting CMOS process, this component element (44) serves for manufacturing further component elements (34, 36) of the electronic component (30),
- from this etching stop material, together with the formation of the component element (44) of the electronic component (30) on the material substrate (12, 14, 16), a bounding region (48), additionally comprising a partial section, is formed along at least a partial section of an edge of the surface structure (26) and comprises a distance, defined in the manufacturing process of the first etching stop material, to the component element (44) of the electronic component (30) comprising the first etching stop material, and
- the material substrate (12, 14, 16) thus formed is selectively etched for forming the surface structure (26), in that an edge the bounding region (48) defines, on the material substrate (12, 14, 16), the position of the surface structure (26) to be formed and thus the surface structure (26) and the electronic component (30) are arranged spaced apart from each other at a distance corresponding to the distance between the component element (44) comprising the first etching stop material and the bounding region (48) comprising the first etching stop material.

2. The method according to claim 1, **characterized in that** a material layer (52) is applied on the material substrate (12, 14, 16), into which, in preparation of the forming of the surface structure (26), an opening (60) aligned with an edge or an edge portion of the surface structure (26) is created, in particular by etching, and that, in a region of the material substrate (12, 14, 16) delimited by the bounding region (48), the edge or edge portion of the surface structure (26) is etched on the material substrate (12, 14, 16) via the opening (60) of the material layer (52).

3. The method according to claim 1 or 2, **characterized in that**, with substantially identical materials for the material substrate (12, 14, 16) and for the first etching stop material, there is formed, below the bounding region (48) defining the position of an edge of edge portion of the surface structure (26), a second etching stop material (46) on the material substrate (12, 14, 16), with the bounding region being (48) at least partially formed on the second etching stop material (46), wherein, during an etching process for etching the edge or edge portion of the surface structure (26) into the material substrate (12, 14, 16), the second etching stop material (46) is etched off, notably with a lower rate than that with which the material substrate (12, 14, 16) is etched.

4. The method according to claim 3, **characterized in that** the material substrate (12, 14, 16) is a monocrystalline silicon and the first etching stop material is a polycrystalline silicon, and that the second etching stop material (46) is silicon oxide.

5. The method according to any one of claims 1 to 4, **characterized in that** the material substrate (12, 14, 16) has a bottom side (20) and a top side (24), that the surface structure (26) comprises the at least one depression which is formed in the top side (24) of the material substrate (12, 14, 16), and that a chamber (18) is formed in the bottom side (20) of the material substrate (12, 14, 16), preferably by etching, wherein, the at least one depression of the surface structure (26) being arranged within the bridging region (22) of the material substrate (12, 14, 16) which bridges the chamber (18).

6. A micro-electromechanical device, comprising:
- a substrate (12, 14, 16) having a top side (24) and a bottom side (20),
- at least one electronic component (30) integrated in the substrate (12, 14, 16), comprising a component element (44) from a first material which defines a position of the component (30), and further component elements (34, 36) which are arranged in a self-adjusted manner by a self-adjusting CMOS process in relation to said component element, and
- at least one surface structure (26), formed in and/or on the top side (24) of the substrate (12, 14, 16), having a bounding edge or a bounding edge portion,
- wherein a bounding region (48), laterally defining the bounding edge or the bounding edge portion of the surface structure (26), is formed from the first material on the top side (24) of the substrate (12, 14, 16) and/or in a region of the substrate (12, 14, 16) close to the top-side along the bounding edge or the bounding edge portion of the surface structure (26) in the substrate (12, 14, 16) at a distance to said component element (44) of the component (30) which is defined by the process of forming the first material,
- wherein the surface structure (26) is arranged spaced apart from the electronic component (30) at a distance corresponding to the distance between the component element (44) comprising the first material and the bounding region (48) comprising the first material.

7. The device according to claim 6, **characterized in that** the electronic component (30) is a transistor with a gate and the component element (44) is the gate of the transistor, or that the electronic component (30) is a resistor and the component element is a resistance layer of the resistor.

8. The device according to claim 6 or 7, **characterized in that** the first material is electroconductive and comprises, in particular, polycrystalline silicon, and that a further region (46) extends along the bounding edge of the surface structure (26) in the substrate (12, 14, 16) from a second material that is electroconductive and comprises, in particular, silicon oxide and on which the first material is disposed.

9. The device according to any one of claims 6 to 8, **characterized in that** the surface structure (26) comprises at least one depression, that a chamber (18) is formed at the bottom side (20) of the substrate (12, 14, 16), and that the at least one depression of the surface structure (26) is arranged within a bridging region (22) of the substrate (12, 14, 16) which bridges the chamber (18).

## Revendications

1. Procédé de fabrication d'un dispositif microélectromécanique dans un substrat de matériau adapté à la fabrication de composants électroniques, en particulier un substrat semi-conducteur, dans lequel, lors du procédé
- un substrat de matériau (12, 14, 16) est préparé, sur lequel au moins une structure de surface (26) sera formée pendant la fabrication du dispositif,
- au moins un composant électronique (30) comportant plusieurs éléments de composant est réalisé dans le substrat de matériau (12, 14, 16) en utilisant des étapes de processus d'un procédé conventionnel de fabrication de composants électroniques intégrés,
- un élément de composant (44) définissant la position du composant électronique (30) est sélectivement réalisé sur le substrat de matériau (12, 14, 16) en un premier matériau d'arrêt de gravure opérant respectivement comme arrêt de gravure pour le cas d'une gravure du substrat de matériau (12, 14, 16) et/ou pour le cas d'une gravure d'une couche de matériau (52) agencée sur le substrat de matériau (12, 14, 16), dans lequel cet élément de composant (44) sert dans un processus CMOS auto-ajustant de fabrication d'autres éléments de composant (34, 36) du composant électronique (30),
- le long d'au moins une section d'un bord de la structure de surface (46), une zone de délimitation (48) comportant cette section est en outre réalisée avec ce matériau d'arrêt de gravure en même temps que la réalisation de l'élément de composant (44) du composant électronique (30) sur le substrat de matériau (12, 14, 16), laquelle possède un écart par rapport à l'élément de composant (44) du composant électronique (30) comportant le premier matériau d'arrêt de gravure qui est défini dans le processus de fabrication du premier matériau d'arrêt de gravure, et
- le substrat de matériau (12, 14, 16) ainsi réalisé est sélectivement gravé afin de former la structure de surface (26), un bord de la zone de délimitation (48) définissant sur le substrat de matériau (12, 14, 16) la position de la structure de surface (26) à réaliser, la structure de surface (26) et le composant électrique (30) étant donc agencés éloignés l'un de l'autre pour correspondre à l'écart entre l'élément de composant (44) comportant le premier matériau d'arrêt de gravure et la zone de délimitation (48) comportant le premier matériau d'arrêt de gravure.

2. Procédé selon la revendication 1, **caractérisé en ce qu'**une couche de matériau (52) est arrangée sur le substrat de matériau (12, 14, 16), une ouverture (60) alignée à un bord ou une section de bord de la structure de surface (26) étant pratiquée lors de la préparation de la réalisation de la structure de surface (26), en particulier par gravure, et **en ce que** l'ouverture (60) de la couche de matériau (52) est gravée à travers le domaine du substrat de matériau (12, 14, 16) délimitée par la zone de délimitation (48) sur ce bord ou cette section de bord de la structure de surface (26).

3. Procédé selon la revendication 1 ou 2, **caractérisé en ce que** lorsque les matériaux pour le substrat de matériau (12, 14, 16) et le premier matériau d'arrêt de gravure sont sensiblement identiques un deuxième matériau d'arrêt de gravure (46), sur lequel la zone de délimitation (48) est au moins en partie réalisée, est réalisé sur le substrat de matériau (12, 14, 16) en-dessous de la zone de délimitation (48) définissant la position d'un bord ou d'une section de bord de la structure de surface (26), dans lequel ce deuxième matériau d'arrêt de gravure (46) est décapé dans le substrat de matériau (12, 14, 16) lors d'une opération de gravure destinée à graver le bord ou la section de bord de la structure de surface (26) dans le substrat de matériau (12, 14, 16), à savoir à une vitesse inférieure à celle à laquelle le substrat de matériau (12, 14, 16) est gravé.

4. Procédé selon la revendication 3, **caractérisé en ce que** le substrat de matériau (12, 14, 16) est un silicium monocristallin et le premier matériau d'arrêt de gravure est un silicium polycristallin et **en ce que** le deuxième matériau d'arrêt de gravure (46) est le dioxyde de silicium.

5. Procédé selon l'une des revendications 1 à 4, **caractérisé en ce que** le substrat de matériau (12, 14, 16) comporte une face inférieure et une face supérieure (20, 24), **en ce que** la structure de surface (26) comporte au moins une dépression, laquelle est réalisée dans la face supérieure (24) du substrat de matériau (12, 14, 16), et **en ce qu'**une chambre (18) est réalisée dans la face inférieure (20) du substrat de matériau (12, 14, 16), en particulier par gravure, dans lequel l'au moins une dépression de la structure de surface (26) est agencée à l'intérieur du domaine (22) du substrat de matériau (12, 14, 16) enjambant la chambre (18).

6. Dispositif microélectromécanique doté
- d'un substrat (12, 14, 16) doté d'une face supérieure (24) et d'une face inférieure (20),
- d'au moins un composant électronique (30) intégré dans le substrat (12, 14, 16), lequel comporte un élément de composant (44) fait d'un premier matériau et définissant la position du composant électronique (30) et d'autres éléments de composant (34, 36), lesquels sont agencés comme auto-ajustés à cet élément de composant par un processus CMOS auto-ajustant, et
- d'au moins une structure de surface (26) réalisée dans et/ou sur la face supérieure (24) du substrat (12, 14, 16), dotée d'un bord de délimitation ou d'une section de bord de délimitation,
- dans lequel une zone de délimitation (48) définissant le bord de délimitation ou la section du bord de délimitation de la structure de surface (26) est réalisée sur la face supérieure (24) et/ou dans le domaine proche de la face supérieure du substrat (12, 14, 16) le long du bord de délimitation ou de la section du bord de délimitation de la structure de surface (26) dans le substrat (12, 14, 16) à un écart par rapport à cet élément de composant (44) du composant (30) défini par le processus de réalisation du premier matériau,
- dans lequel la structure de surface (26) est agencée éloignée du composant électronique (30) pour correspondre à l'écart entre l'élément de composant (44) comportant le premier matériau et la zone de délimitation (48) comportant le premier matériau.

7. Dispositif selon la revendication 6, **caractérisé en ce que** le composant électronique (30) est un transistor doté d'une grille et l'élément de composant (44) est la grille du transistor ou **en ce que** le composant électronique (30) est une résistance et l'élément de composant (44) est la couche de résistance de la résistance.

8. Dispositif selon la revendication 6 ou 7, **caractérisé en ce que** le premier matériau est électriquement conducteur et comprend en particulier du silicium polycristallin et **en ce qu'**une autre zone (46) faite d'un deuxième matériau s'étend dans le substrat (12, 14, 16) le long du bord de délimitation de la structure de surface (26), laquelle est électriquement isolante et comporte en particulier du dioxyde de silicium et sur laquelle est agencé le premier matériau.

9. Dispositif selon l'une des revendications 6 à 8, **caractérisé en ce que** la structure de surface (26) comporte au moins une dépression, **en ce qu'**une chambre (18) est réalisée sur la face inférieure (20) du substrat (12, 14, 16) et **en ce que** l'au moins une dépression de la structure de surface (26) est agencée à l'intérieur d'un domaine (22) du substrat (12, 14, 16) enjambant la chambre (18).
